(19) Europäisches Patentamt
European Patent Office
Office européen des brevets

(11) **EP 2 567 174 B1**

(12) # EUROPEAN PATENT SPECIFICATION

(45) Date of publication and mention
of the grant of the patent:
**26.02.2020 Bulletin 2020/09**

(21) Application number: **11777334.1**

(22) Date of filing: **13.05.2011**

(51) Int Cl.:
*F28F 3/04* (2006.01)    *F28F 21/02* (2006.01)
*H01L 23/367* (2006.01)    *H01L 23/373* (2006.01)
*H01L 23/46* (2006.01)    *F28F 13/06* (2006.01)

(86) International application number:
**PCT/IB2011/001026**

(87) International publication number:
**WO 2011/138670 (10.11.2011 Gazette 2011/45)**

(54) **FRACTAL HEAT TRANSFER DEVICE**

FRAKTALWÄRMETRANSFERVORRICHTUNG

DISPOSITIF DE TRANSFERT THERMIQUE FRACTAL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**13.03.2013 Bulletin 2013/11**

(73) Proprietor: **Poltorak, Alexander
Monsey, NY 10952-2015 (US)**

(72) Inventor: **Poltorak, Alexander
Monsey, NY 10952-2015 (US)**

(74) Representative: **Mozzi, Matteo et al
Jacobacci & Partners S.p.A.
Via Senato, 8
20121 Milano (IT)**

(56) References cited:
EP-A1- 1 164 269    CN-A- 101 394 730
JP-A- 2000 068 427    JP-A- 2000 156 578
TW-A- 200 819 700    US-A- 5 870 284
US-A1- 2002 080 563    US-A1- 2003 183 368
US-A1- 2006 237 178    US-A1- 2008 080 137
US-A1- 2008 115 916    US-A1- 2009 321 045
US-B1- 6 323 432    US-B1- 6 390 181
US-B1- 6 397 926    US-B1- 6 437 438
US-B1- 6 807 059    US-B2- 7 351 360

• FUCHS S ET AL: "A REVIEW OF SUBSTRATE
MATERIALS FOR POWER HYBRID CIRCUITS",
INTERNATIONAL JOURNAL OF MICROCIRCUITS
AND ELECTRONIC PACKAGING,
INTERNATIONAL MICROELECTRONICS &
PACKAGING SOCIETY, US, vol. 20, no. 1, 1
January 1997 (1997-01-01), pages 61-66,
XP000686992, ISSN: 1063-1674
• LIU ET AL.: 'Heat Transfer and Pressure Drop in
Fractal Microchannel Heat Sink for Cooling of
Electronic Chips' HEAT MASS TRANSFER vol.
44, no. 2, 01 December 2007, pages 221 - 227,
XP019560208 DOI: 10.1007/S00231-007-0240-0

**Description**

FIELD OF THE INVENTION

This invention relates to the field of heatsinks or items that transfer heat between a concentrated source or sink and a fluid. Such a heat sink is e.g. known from US 2008/00115916 A1 or US 2008/0080137 A1, which show the preamble of claim 1.

BACKGROUND OF THE INVENTION

A heat sink is a term for a component or assembly that transfers heat generated within a solid material to a fluid medium, such as air or a liquid. A heat sink is typically physically designed to increase the surface area in contact with the cooling fluid surrounding it, such as the air. Approach air velocity, choice of material, fin (or other protrusion) design and surface treatment are some of the design factors which influence the thermal resistance, i.e. thermal performance, of a heat sink.

A heat sink transfers thermal energy from a higher temperature to a lower temperature *fluid medium.* The fluid medium is frequently air, but can also be water or in the case of heat exchangers, refrigerants and oil. Fourier's law of heat conduction, simplified to a one-dimensional form in the x-direction, shows that when there is a temperature gradient in a body, heat will be transferred from the higher temperature region to the lower temperature region. The rate at which heat is transferred by conduction, $q_k$, is proportional to the product of the temperature gradient and the cross-sectional area through which heat is transferred:

$$q_k = -kA\frac{dT}{dx} \tag{1}$$

where $q_k$ is the rate of conduction, k is a constant which depends on the materials that are involved, *A* is the surface area through which the heat must pass, and *dT/dx* is the rate of change of temperature with respect to distance (for simplicity, the equation is written in one dimension). Thus, according to Fourier's law (which is not the only consideration by any means), heatsinks benefit from having a large surface area exposed to the medium into which the heat is to be transferred.

Consider a heat sink in a duct, where air flows through the duct, and the heat sink base is higher in temperature than the air. Assuming conservation of energy, for steady-state conditions, and applying Newton's law of cooling, gives the following set of equations.

$$\dot{Q} = \dot{m}c_{p,in}\left(T_{air,out} - T_{air,in}\right) \tag{2}$$

$$\dot{Q} = \frac{T_{hs} - T_{air,av}}{R_{hs}} \tag{3}$$

where

$$T_{air,av} = \frac{T_{air,out} + T_{air,in}}{2} \tag{4}$$

Using the mean air temperature is an assumption that is valid for relatively short heat sinks. When compact heat exchangers are calculated, the logarithmic mean air temperature is used. $\dot{m}$ is the air mass flow rate in kg/s.

The above equations show that when the air flow through the heat sink decreases, this results in an increase in the average air temperature. This in turn increases the heat sink base temperature. And additionally, the thermal resistance of the heat sink will also increase. The net result is a higher heat sink base temperature. The inlet air temperature relates strongly with the heat sink base temperature. Therefore, if there is no air or fluid flow around the *heat sink,* the energy dissipated to the air cannot be transferred to the ambient air. Therefore, the heat sink functions poorly.

Other examples of situations in which a heat sink has impaired efficiency: Pin fins have a lot of surface area, but the pins are so close together that air has a hard time flowing through them; Aligning a heat sink so that the fins are not in the direction of flow; Aligning the fins horizontally for a natural convection heat sink. Whilst a heat sink is stationary and there are no centrifugal forces and artificial gravity, air that is warmer than the ambient temperature *always* flows upward, given essentially-still-air surroundings; this is convective cooling.

The most common heat sink material is aluminum. Chemically pure aluminum is not used in the manufacture of heat sinks, but rather aluminum alloys. Aluminum alloy 1050A has one of the higher thermal conductivity values at 229 W/m•K. However, it is not recommended for machining, since it is a relatively soft material. Aluminum alloys 6061 and 6063 are the more commonly used aluminum alloys, with thermal conductivity values of 166 and 201 W/m•K, respectively. The aforementioned values are dependent on the temper of the alloy.

Copper is also used since it has around twice the conductivity of aluminum, but is three times as heavy as aluminum. Copper is also around four to six times more expensive than aluminum, but this is market dependent. Aluminum has the added advantage that it is able to be extruded, while copper cannot. Copper heat sinks are machined and skived. Another method of manufacture is to solder the fins into the heat sink base.

Another heat sink material that can be used is diamond. With a value of 2000 W/mK it exceeds that of copper by a factor of five. In contrast to metals, where heat is conducted by delocalized electrons, lattice vibrations are responsible for diamond's very high thermal conductivity. For thermal management applications, the outstanding thermal conductivity and diffusivity of diamond is an essential. CVD diamond may be used as a sub-mount for high-power integrated circuits and laser diodes.

Composite materials can be used. Examples are a copper-tungsten pseudoalloy, AlSiC (silicon carbide in aluminum matrix), Dymalloy (diamond in copper-silver alloy matrix), and E-Material (beryllium oxide in beryllium matrix). Such materials are often used as substrates for chips, as their thermal expansion coefficient can be matched to ceramics and semiconductors.

Fin efficiency is one of the parameters which makes a higher thermal conductivity material important. A fin of a heat sink may be considered to be a flat plate with heat flowing in one end and being dissipated into the surrounding fluid as it travels to the other. As heat flows through the fin, the combination of the thermal resistance of the heat sink impeding the flow and the heat lost due to convection, the temperature of the fin and, therefore, the heat transfer to the fluid, will decrease from the base to the end of the fin. This factor is called the fin efficiency and is defined as the actual heat transferred by the fin, divided by the heat transfer were the fin to be isothermal (hypothetically the fin having infinite thermal conductivity). Equations 5 and 6 are applicable for straight fins.

$$\eta_f = \frac{tanh(mL_c)}{mL_c} \tag{5}$$

$$mL_c = \sqrt{\frac{2h_f}{kt_f}}L_f \tag{6}$$

Where:

- $h_f$ is the convection coefficient of the fin

    ◦ Air: 10 to 100 W/(m$^2$K)
    ◦ Water: 500 to 10,000 W/(m$^2$K)

- k is the thermal conductivity of the fin material
    ◦ Aluminum: 120 to 240 W/(m·K)
- $L_f$ is the fin height (m)
- $t_f$ is the fin thickness (m)

Another parameter that concerns the thermal conductivity of the heat sink material is spreading resistance. Spreading resistance occurs when thermal energy is transferred from a small area to a larger area in a substance with finite thermal conductivity. In a heat sink, this means that heat does not distribute uniformly through the heat sink base.

The spreading resistance phenomenon is shown by how the heat travels from the heat source location and causes a large temperature gradient between the heat source and the edges of the heat sink. This means that some fins are at a lower temperature than if the heat source were uniform across the base of the heat sink. This non-uniformity increases the heat sink's effective thermal resistance.

A pin fin heat sink is a heat sink that has pins that extend from its base. The pins can be, for example, cylindrical, elliptical or square. A second type of heat sink fin arrangement is the straight fin. These run the entire length of the heat sink. A variation on the straight fin heat sink is a cross cut heat sink. A straight fin heat sink is cut at regular intervals but at a coarser pitch than a pin fin type.

In general, the more surface area a heat sink has, the better it works. However, this is not always true. The concept of a pin fin heat sink is to try to pack as much surface area into a given volume as possible. As well, it works well in any orientation. Kordyban has compared the performance of a pin fin and a straight fin heat sink of similar dimensions. Although the pin fin has 194 cm$^2$ surface area while the straight fin has 58 cm$^2$, the temperature difference between the heat sink base and the ambient air for the pin fin is 50 °C. For the straight fin it was 44 °C or 6 °C better than the pin fin. Pin fin heat sink performance is significantly better than straight fins when used in their intended application where the fluid flows axially along the pins rather than only tangentially across the pins.

Another configuration is the flared fin heat sink; its fins are not parallel to each other, but rather diverge with increasing distance from the base. Flaring the fins decreases flow resistance and makes more air go through the heat sink fin channel; otherwise, more air would bypass the fins. Slanting them keeps the overall dimensions the same, but offers longer fins. Forghan, et al. have published data on tests conducted on pin fin, straight fin and flared fin heat sinks. They found that for low approach air velocity, typically around 1 m/s, the thermal performance is at least 20% better than straight fin heat sinks. Lasance and Eggink also found that for the bypass configurations that they tested, the flared heat sink performed better than the other heat sinks tested.

The heat transfer from the heatsink is mediated by two effects: conduction via the coolant, and thermal radiation. The surface of the heatsink influences its emissivity; shiny metal absorbs and radiates only a small amount of heat, while matte black radiates highly. In coolant-mediated heat transfer, the contribution of radiation is generally small. A layer of coating on the heatsink can then be counterproductive, as its thermal resistance can impair heat flow from the fins to the coolant. Finned heatsinks with convective or forced flow will not benefit significantly from being colored. In situations with significant contribution of radiative cooling, e.g. in case of a flat non-finned panel acting as a heatsink with low airflow, the heatsink surface finish can play an important role. Matte-black surfaces will radiate much more efficiently than shiny bare metal. The importance of radiative vs. coolant-mediated heat transfer increases in situations with low ambient air pressure (e.g. high-altitude operations) or in vacuum (e.g. satellites in space).

Fourier, J. B., 1822, Theorie analytique de la chaleur, Paris; Freeman, A., 1955, translation, Dover Publications, Inc, NY.

Kordyban, T., 1998, Hot air rises and heat sinks - Everything you know about cooling electronics is wrong, ASME Press, NY.

Anon, Unknown, "Heat sink selection", Mechanical engineering department, San Jose State University [27 January 2010] www.engr.sjsu.edu/ndejong/ME%20146%20files/Heat%20Sink.pptwww.engr.sjsu.edu/n dejong/ME%20146%20files/Heat%20Sink.ppt

Sergent, J. and Krum, A., 1998, Thermal management handbook for electronic assemblies, First Edition, Mc-Graw-Hill.

Incropera, FP and DeWitt, DP, 1985, Introduction to heat transfer, John Wiley & Sons NY.

Forghan, F., Goldthwaite, D., Ulinski, M., Metghalchi, M., 2001, Experimental and Theoretical Investigation of Thermal Performance of Heat Sinks, ISME May.

Lasance, C.J.M and Eggink, H.J., 2001, A Method to Rank Heat Sinks in Practice: The Heat Sink Performance Tester, 21st IEEE SEMI-THERM Symposium.

ludens.cl/Electron/Thermal.html

Lienard, J.H., IV & V, 2004, A Heat Transfer Textbook, Third edition, MIT

Saint-Gobain, 2004, "Thermal management solutions for electronic equipment" 22 July 2008 www.fff.saint-gobain.com/Media/Documents/S0000000000000001036/ ThermaCool%20Brochure.pdf

Jeggels, Y.U., Dobson, R.T., Jeggels, D.H., Comparison of the cooling performance between heat pipe and aluminium conductors for electronic equipment enclosures, Proceedings of the 14th International Heat Pipe Conference, Florianopolis, Brazil, 2007.

Prstic, S., Iyengar, M., and Bar-Cohen, A., 2000, Bypass effect in high performance heat sinks, Proceedings of the International Thermal Science Seminar Bled, Slovenia, June 11 - 14.

Mills, A.F., 1999, Heat transfer, Second edition, Prentice Hall.

Potter, C.M. and Wiggert, D.C., 2002, Mechanics of fluid, Third Edition, Brooks/Cole.

White, F.M., 1999, Fluid mechanics, Fourth edition, McGraw-Hill International.

Azar, A, et al., 2009, "Heat sink testing methods and common oversights", Qpedia Thermal E-Magazine, January 2009 Issue. www.qats.com/cpanel/UploadedPdf/January20092.pdf

Several structurally complex heatsink designs are discussed in Hernon, US App. 2009/0321045.

Heatsinks operate by removing heat from an object to be cooled into the surrounding air, gas or liquid through convection and radiation. Convection occurs when heat is either carried passively from one point to another by fluid motion (forced convection) or when heat itself causes fluid motion (free convection). When forced convection and free convection occur together, the process is termed mixed convection. Radiation occurs when energy, for example in the form of heat, travels through a medium or through space and is ultimately absorbed by another body. Thermal radiation is the process by which the surface of an object radiates its thermal energy in the form of electromagnetic waves. Infrared radiation from a common household radiator or electric heater is an example of thermal radiation, as is the heat and light (IR and visible EM waves) emitted by a glowing incandescent light bulb. Thermal radiation is generated when heat from the movement of charged particles within atoms is converted to electromagnetic radiation.

A heatsink tends to decrease the maximum temperature of the exposed surface, because the power is transferred to a larger volume. This leads to a possibility of diminishing return on larger heatsinks, since the radiative and convective dissipation tends to be related to the temperature differential between the heatsink surface and the external medium. Therefore, if the heatsink is oversized, the efficiency of heat shedding is poor. If the heatsink is undersized, the object may be insufficiently cooled, the surface of the heatsink dangerously hot, and the heat shedding not much greater than the object itself absent the heatsink.

The relationship between friction and convention in heatsinks is discussed by Frigus Primore in "A Method for Comparing Heat Sinks Based on Reynolds Analogy," available at www.frigprim.com/downloads/Reynolds_analogy_heatsinks.PDF, last accessed April 28, 2010. This article notes that for, plates, parallel plates, and cylinders to be cooled, it is necessary for the velocity of the surrounding fluid to be low in order to minimize mechanical power losses. However, larger surface flow velocities will increase the heat transfer efficiency, especially where the flow near the surface is turbulent, and substantially disrupts a stagnant surface boundary layer. Primore also discusses heatsink fin shapes and notes that no fin shape offers any heat dissipation or weight advantage compared with planar fins, and that straight fins minimize pressure losses while maximizing heat flow. Therefore, the art generally teaches that generally flat and planar surfaces are appropriate for most heatsinks.

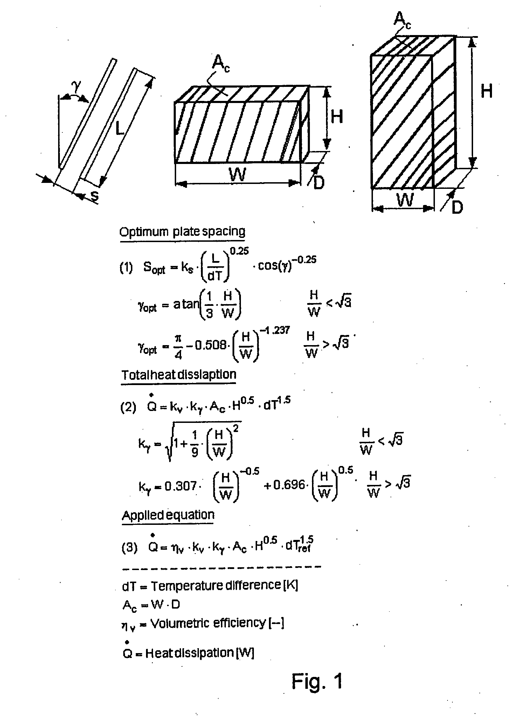

Frigus Primore, "Natural Convection and Inclined Parallel Plates," www.frigprim.com/articels2/parallel_pl_Inc.html, last accessed April 29, 2010, discusses the use of natural convection (i.e., convection due to the thermal expansion of a gas surrounding a solid heatsink in normal operating conditions) to cool electronics. One of the design goals of various heatsinks is to increase the rate of natural convection. Primore suggests using parallel plates to attain this result. Once again, Primore notes that parallel plate heat sinks are the most efficient and attempts to define the optimal spacing and angle (relative to the direction of the fluid flow) of the heat sinks according to the equations in Fig. 1.

In another article titled "Natural Convection and Chimneys," available at www.frigprim.com/articels2/parallel_plchim.html, last accessed April 29, 2010, Frigus Primore discusses the use of parallel plates in chimney heat sinks. One purpose of this type of design is to combine more efficient natural convection with a chimney. Primore notes that the design suffers if there is laminar flow (which creates a re-circulation region in the fluid outlet, thereby completely eliminating the benefit of the chimney) but benefits if there is turbulent flow which allows heat to travel from the parallel plates into the chimney and surrounding fluid.

In "Sub-Grid Turbulence Modeling for Unsteady Flow with Acoustic Resonance," available at www.metacomptech.com/cfd++/00-0473.pdf, last accessed April 29, 2010, Paul Batten et al discuss that when a fluid is flowing around an obstacle, localized geometric features, such as concave regions or cavities, create pockets of separated flow which can generate self-sustaining oscillations and acoustic resonance. The concave regions or cavities serve to substantially reduce narrow band acoustic resonance as compared to flat surfaces. This is beneficial to a heat sink in a turbulent flow environment because it allows for the reduction of oscillations and acoustic resonance, and therefore for an increase in the energy available for heat transfer.

In S. Liu, "Heat Transfer and Pressure Drop in Fractal Microchannel Heat Sink for Cooling of Electronic Chips," 44 Heat Mass Transfer 221 (2007), Liu et al discuss a heatsink with a "fractal-like branching flow network." Liu's heatsink includes channels through which fluids would flow in order to exchange heat with the heatsink.

Y.J. Lee, "Enhanced Microchannel Heat Sinks Using Oblique Fins," IPACK 2009-89059, similarly discusses a heat sink comprising a "fractal-shaped microchannel based on the fractal pattern of mammalian circulatory and respiratory system." Lee's idea, similar to that of Liu, is that there would be channels inside the heatsink through which a fluid could flow to exchange heat with the heatsink. The stated improvement in Lee's heatsink is (1) the disruption of the thermal boundary layer development; and (2) the generation of secondary flows.

Pence, D. V., 2002, "Reduced Pumping Power and Wall Temperature in Microchannel Heat Sinks with Fractal-like Branching Channel Networks", Microscale Thermophys. Eng. 5, pp. 293-311, similarly, mentions heatsinks that have fractal-like channels allowing fluid to enter into the heat sink. The described advantage of Pence's structure is increased exposure of the heat sink to the fluid and lower pressure drops of the fluid while in the heatsink.

In general, a properly designed heatsink system will take advantage of thermally induced convection or forced air (e.g., a fan). In general, a turbulent flow near the surface of the heatsink disturbs a stagnant surface layer, and improves performance. In many cases, the heatsink operates in a non-ideal environment subject to dust or oil; therefore, the heatsink design must accommodate the typical operating conditions, in addition to the as-manufactured state.

Prior art heatsink designs have traditionally concentrated on geometry that is Euclidian, involving structures such as the pin fins, straight fins, and flares discussed above.

NJ Ryan, DA Stone, "Application of the FD-TD method to modelling the electromagnetic radiation from heatsinks", IEEE International Conference on Electromagnetic Compatibility, 1997. 10th (1-3 Sep 1997), pp: 119 - 124, discloses a fractal antenna which also serves as a heatsink in a radio frequency transmitter.

Lance Covert, Jenshan Lin, Dan Janning, Thomas Dalrymple, "5.8 GHz orientation-specific extruded-fin heatsink antennas for 3D RF system integration", 23 APR 2008 DOI: 10.1002/mop.23478, Microwave and Optical Technology Letters Volume 50, Issue 7, pages 1826-1831, July 2008 also provide a heatsink which can be used as an antenna.

SUMMARY OF THE INVENTION

The objects of the present invention are achieved by an heatsink and a method of cooling a solid as defined into the appended claims.

Most heatsinks are designed using a linear or exponential relationship of the heat transfer and dissipating elements. A known geometry which has not generally been employed is fractal geometry. Some fractals are random fractals, which are also termed chaotic or Brownian fractals and include random noise components. In deterministic fractal geometry, a self-similar structure results from the repetition of a design or motif (or "generator") using a recursive algorithm, on a series of different size scales. As a result, certain types of fractal images or structures appear to have self-similarity over a broad range of scales. On the other hand, no two ranges within the design are identical.

A fractal is defined as "a rough or fragmented geometric shape that can be split into parts, each of which is (at least approximately) a reduced-size copy of the whole." Mandelbrot, B.B. (1982). That is, there is a recursive algorithm which describes the structure. The Fractal Geometry of Nature. W.H. Freeman and Company. ISBN 0-7167-1186-9. This property is termed "self-similarity." For a more detailed discussion of fractals, see the Wikipedia article thereon at en.wikipedia.org/wiki/Fractal (last accessed April 14, 2010). Exemplary images of well-known fractal designs can also be viewed on the Wikipedia page. Due to the fact that fractals involve largely self-repeating patterns, each of which serves to increase the surface area in three-dimensional fractals (perimeter in two-dimensional fractals), three dimensional fractals in theory are characterized by infinite surface area (and two-dimensional fractals are characterized by infinite perimeter). In practical implementations, the scale of the smallest features which remain true to the generating algorithm may be 3-25 iterations of the algorithm. Less than three recursions, and the fractal nature is not apparent, while present manufacturing technologies limit the manufacture of objects with a large range of feature scales.

This fractal nature is useful in a heatsink because the rate at which heat is transferred from a surface, either through convection or through radiation, is typically related to, and increasing with, the surface area. Of course, due to limitations in the technology used to build these heatsinks, engineering compromise is expected. However a feature of an embodiment of the designs proposed herein is that vortices induced by fluid flow over a heat transfer surface will be chaotically distributed over various elements of the surface, thus disrupting the stagnant surface boundary layer and increasing the effective surface area available for heat transfer, while avoiding acoustic resonance which may be apparent from a regular array of structures which produce vortices and turbulence.

Further, a large physical surface area to volume ratio, which is generally useful in heatsink design, can still be obtained using the fractal model. In addition, fractal structures provide a plurality of concave regions or cavities, providing pockets of separated flow which can generate self-sustaining oscillations and acoustic resonance. These pockets serve to reduce the acoustic resonance in turbulent flowing fluid (as compared to flat or Euclidian surfaces), thus allowing for more effective heat transfer between the fractal structure and the surrounding fluid, thereby making the fractal structure ideal for a heatsink.

US Patent 7,256,751, issued to Cohen, discusses fractal antennas. In the background of this patent, Cohen discusses Kraus' research, noting that Euclidian antennas with low area (and therefore low perimeter) exhibit very low radiation resistance and are thus inefficient. Cohen notes that the advantages of fractal antennas, over traditional antennas with Euclidian geometries, is that they can maintain the small area, while having a larger perimeter, allowing for a higher radiation resistance. Also, Cohen's fractal antenna features non-harmonic resonance frequencies, good bandwidth, high efficiency, and an acceptable standing wave ratio.

In the instant invention, this same wave theory may be applied to fractal heatsinks, especially with respect to the interaction of the heat transfer fluid with the heatsink. Thus, while the heat conduction within a solid heatsink is typically not modeled as a wave (though modern thought applies phonon phenomena to graphene heat transport), the fluid surrounding the heating certainly is subject to wave phenomena, complex impedances, and indeed the chaotic nature of fluid eddies may interact with the chaotic surface configuration of the heatsink.

The efficiency of capturing electric waves in a fractal antenna, achieved by Cohen, in some cases can be translated into an efficiency transferring heat out of an object to be cooled in a fractal heatsink as described herein. See, Boris Yakobson, "Acoustic waves may cool microelectronics", Nano Letters, ACS (2010). Some physics scholars have suggested that heat can be modeled as a set of phonons. Convection and thermal radiation can therefore be modeled as the movement of phonons. A phonon is a quasiparticle characterized by the quantization of the modes of lattice vibration of solid crystal structures. Any vibration by a single phonon is in the normal mode of classical mechanics, meaning that the lattice oscillates in the same frequency. Any other arbitrary lattice vibration can be considered a superposition of these elementary vibrations. Under the phonon model, heat travels in waves, with a wavelength on the order of 1 $\mu$m. In most materials, the phonons are incoherent, and therefore a macroscopic scales, the wave nature of heat transport is not apparent or exploitable.

The thermodynamic properties of a solid are directly related to its phonon structure. The entire set of all possible phonons combine in what is known as the phonon density of states which determines the heat capacity of a crystal. At absolute zero temperature (0 Kelvin or -273 Celsius), a crystal lattice lies in its ground state, and contains no phonons. A lattice at a non-zero temperature has an energy that is not constant, but fluctuates randomly about some mean value. These energy fluctuations are caused by random lattice vibrations, which can be viewed as a gas-like structure of phonons or thermal phonons. However, unlike the atoms which make up an ordinary gas, thermal phonons can be created and destroyed by random energy fluctuations. In the language of statistical mechanics this means that the chemical potential for adding a phonon is zero. For a more detailed description of phonon theory, see the Wikipedia article thereon available at en.wikipedia.org/wiki/Phonon (last accessed April 16, 2010).

In certain materials, such as graphene, phonon transport phenomena are apparent at macroscopic levels, which make phonon impedance measurable and useful. Thus, if a graphene sheet were formed to resonate at a particular phonon wavelength, the resonant energy would not be emitted. On the other hand, if the graphene sheet were configured using a fractal geometry, the phonon impedance would be well controlled over a broad range of wavelengths, with sharp resonances at none, leading to an efficient energy dissipation device.

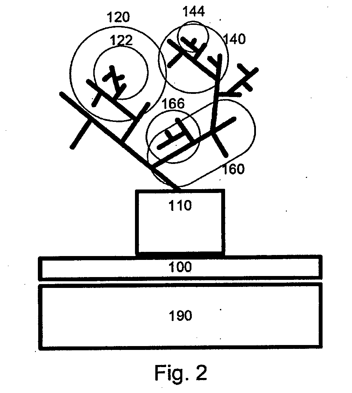

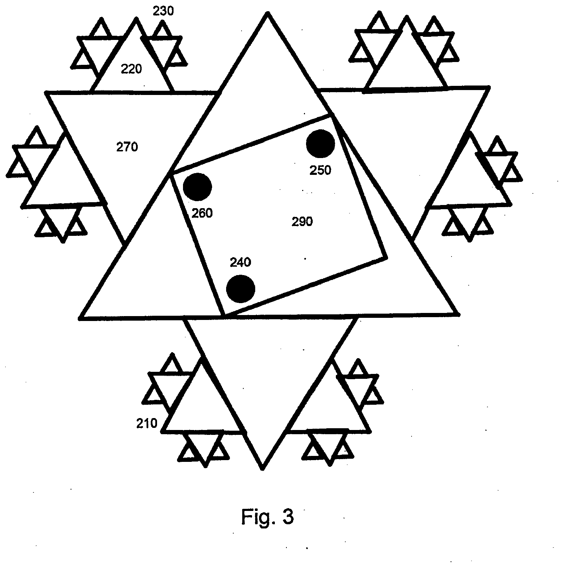

Many fractal designs are characterized by concave regions or cavities. See, for example, Figs. 2 and 3. While sets of concavities may be useful in improving aerodynamics and fluid dynamics to increase turbulence, if they are disposed in a regular array, they will likely produce an acoustic resonance, and may have peaks in a fluid impedance function. On the other hand, the multiscale nature of a fractal geometric design will allow the system to benefit from the concavities, while avoiding a narrowly tuned system.

The present system proposes a fractal-shaped heatsink for the purpose of dissipating heat. The benefits of a fractal heatsink, over a traditional heatsink having a Euclidian geometry may include: (1) the fractal heatsink has a greater surface area, allowing for more exposure of the hot device to the surrounding air or liquid and faster dissipation of heat; and (2) due to the plethora of concave structures or cavities in fractal structures, the fractal heatsink is better able to take advantage of flow mechanics than a traditional heatsink, resulting in heat entering and exiting the heatsink more quickly (3) acoustic properties, especially in forced convection systems.

The invention provides a heatsink to cool an object through convection or radiation. For the smallest heatsink elements, on the order of 10-100 nm, the focus of the heat transfer will be on radiation rather than convection. Electron emission and ionization may also be relevant. Larger heatsink elements, approximately >1 mm in size, will generally rely on convection as the primary form of heat transfer.

In one embodiment, the heatsink comprises a heat exchange device with a plurality of heat exchange elements having a fractal variation therebetween. A heat transfer fluid, such as air, water, or another gas or liquid, is induced to flow through the heat exchange device. The heat transfer fluid has turbulent portions. The fractal variation in the plurality of heat exchange elements substantially reduces the narrow band acoustic resonance as compared to a heatsink having a linear or Euclidian geometric variation between the plurality heat exchange elements. The turbulent flow also disturbs the stagnant surface boundary layer, leading to more efficient heat transfer.

When a heat transfer fluid (air, gas or liquid) is induced to flow over a surface, there may be turbulence in the fluid. The fractal shape of the heatsink serves to reduce the energy lost due to the turbulence, while increasing the surface area of the heatsink subject to turbulence, due to the plethora of concave regions, cavities, and pockets. Therefore, the efficiency of heat transfer may be increased as compared to a heat exchange device having a linear or Euclidian geometric variation between several heat exchange elements.

Preferably, the heat exchange device will include a highly conductive substance whose heat conductivity exceeds 850 W/(m*K). Examples of such superconductors include graphene, diamond, and diamond-like coatings. Alternatively, the heat exchange device may include carbon nanotubes.

Various variations on this heatsink will be apparent to skilled persons in the art. For example, the heatsink could include a heat transfer surface that is connected to the heat exchange device and is designed to accept a solid to be cooled. Alternatively, there could be a connector that is designed to connect with a solid to be cooled in at least one point. In another embodiment, there are at least three connectors serving to keep the solid and the heatsink in a fixed position relative to one another. Various connectors will be apparent to persons skilled in the art. For example, the connector could be a point connector, a bus, a wire, a planar connector or a three-dimensional connector. In another embodiment, the heatsink has an aperture or void in the center thereof designed to accept a solid to be cooled.

This heatsink is intended to be used to cool objects, and may be part of a passive or active system. Modern three-dimensional laser and liquid printers can create objects such as the heatsinks described herein with a resolution of features on the order of about 16 $\mu$m, making it feasible for those of skilled in the art to use such fabrication technologies to produce objects with a size below 10 cm. Alternatively, larger heatsinks, such as car radiators, can be manufactured in a traditional manner, designed with an architecture of elements having a fractal configuration. For example, a liquid-to-gas heat exchanger (radiator) may be provided in which segments of fluid flow conduit have a fractal relationship over three levels of recursion, i.e., paths with an average of at least two branches. Other fractal design concepts may be applied concurrently, as may be appropriate.

Yet another embodiment of the invention involves a method of cooling a solid by connecting the solid with a heatsink. The heatsink comprises a heat exchange device having a plurality of heat exchange elements having a fractal variation therebetween. A heat transfer fluid having turbulent portions is induced to flow with respect to the plurality of heat exchange elements. The fractal variation in the plurality of heat exchange elements serves to substantially reduce narrow band resonance as compared to a corresponding heat exchange device having a linear or Euclidean geometric variation between a plurality of heat exchange elements.

An example of the invention, not claimed, provides a surface of a solid heatsink, e.g., an internal or external surface, having fluid thermodynamical properties adapted to generate an asymmetric pattern of vortices over the surface over a range of fluid flow rates. For example, the range may comprise a range of natural convective fluid flow rates arising from use of the heatsink to cool a heat-emissive object. The range may also comprise a range of flow rates arising from a forced convective flow (e.g., a fan) over the heatsink.

The heatsink may cool an unconstrained or uncontained fluid, generally over an external surface of a heatsink, or a constrained or contained fluid, generally within an internal surface of a heatsink.

## BRIEF DESCRIPTION OF THE DRAWINGS

. Fig. 1 shows a set of governing equations for a parallel plate heatsink.

. Fig. 2 illustrates a fractal heatsink that is an exemplary embodiment of the invention. In this embodiment, the heatsink is placed adjacent to the object to be cooled.

. Fig. 3 illustrates a fractal heatsink that is an exemplary embodiment of the invention. In this embodiment, the heatsink is placed either adjacent to or surrounding the object to be cooled.

## DETAILED DESCRIPTION OF THE PREFERRED EMBODIMENTS

**Fig. 2** illustrates a heatsink implementing an exemplary embodiment of this invention. Note that the illustration is in two dimensions, but a three dimensional embodiment is both possible and preferred. There is a heat transfer surface **100** that allows the heatsink to rest comfortably on a surface, such as the solid to be cooled **190.** In the illustrated embodiment, the heat transfer surface **100** is roughly planar, having a closed Euclidian cross-section on the bottom. However, it might also have another shape, for example if the solid to be cooled does not have a planar face. A fractal-shaped heat exchange device begins at point **110.** While only one fractal heatsink is illustrated here, skilled persons in the art will recognize other similar fractal heatsinks that are also intended to be covered by the invention. Note that the heatsink has three branches leaving from point **110** - branch **120,** branch **140,** and branch **160.** Also note that the branch structure initiating from point **110** is nearly identical to that at point **122** and **142,** even though only point **110** is a true starting point. Thus, the fractal property of self-similarity is preserved. We call the structure that begins at point **110** the "first motif," the structure from point **122** the "second motif," and the structure that begins from point **142** the "third motif." Note that, in the embodiment illustrated in **Fig. 2,** the replication from first to second motif and from second to third motif involves a linear displacement (upward) and a change of scale. In branches not going in the same direction as the prior branch, there is also a rotation. Under the limitations for ideal fractals, the second motif and third motif must be a smaller, exact copy of the first motif. However, due to the limitations imposed by human-made structures and machines, the fractals designed here are generally finite and the second motif will thus be an inexact copy of the first motif, i.e. if there are N levels starting from the first motif, the second motif level will have N-1 levels, if N is very large, the difference is insignificant. In other words, the self-similarity element required in fractals is not preserved perfectly in the preferred designs due to the limitations of available machinery. In addition, the benefits are achieved without requiring fractal relationships over more than a few "orders" of magnitude (iterations of the fractal recursive algorithm). For example, in the embodiment illustrated in **Fig. 2,** there are no continuing branch divisions and iterations at point **162,** even though an ideal fractal would have them. In an ideal fractal, there would be an infinite number of sub-branches from **110, 122,** and **142.** However, an imperfect fractal shape, as illustrated in **Fig. 2,** will serve the purposes of this invention.

Persons of ordinary skill in the art will appreciate the advantages offered by the structure **110** in **Fig. 2.** The fractal heatsink has a much larger surface area than the heat transfer surface alone because all of the "branches" and "leaves" of the fern-like fractal shape serve to increase the surface area. In addition, if a heat transfer fluid is induced to flow above the heat transfer surface 100, the turbulent portions of the heat transfer fluid near the surface will be increased by the textures inherent in the fractal variation in the heat exchange element **110.** Because the fractal patterns is itself non-identically repeating within the fractal design, this will serve to substantially reduce narrow band acoustic resonance as compared to a corresponding heat exchange device having a repeating design, e.g., a linear or geometric variation between several heat exchange elements, thereby further aiding in the heat transfer process.

In a preferred embodiment, the heat transfer surface **100** and the roughly fractal-shaped heat exchange element **110** are all made out of an efficient heat conductor, such as copper or aluminum, or more preferably, having a portion whose heat conductivity exceeds 850 W/(m*K), such as graphene with a heat conductivity of between 4840 and 5300 W/(m*K) or diamond with a heat conductivity between 900 and 2320 W/(m*K). This would allow heat to quickly enter the heatsink from the solid and for heat to quickly exit the heatsink through the branches and leaves of the fern-like fractal **110.** In another embodiment, the heatsink is formed, at least in part, of carbon nanotubes, which display anisotropic heat conduction, with an efficient heat transfer along the long axis of the tube. Carbon nanotubes are submicroscopic hollow tubes made of a chicken-wire-like or lattice of carbon atoms. These tubes have a diameter of just a few nanometers and are highly heat conductive, transferring heat much faster than diamond, and in some cases comparable to graphene. See web.mit.edu/press/2010/thermopower-waves.html (last accessed April 15, 2010).

Also note that this exemplary embodiment provides a plethora of openings, e.g. **124** and **126,** between the branches or fractal subelements to ensure that all of the branches are exposed to the surrounding air, gas or liquid and to allow the heat to escape from the heatsink into the surroundings. In one embodiment of the invention, at least two of these openings are congruent, as are openings **124** and **126** illustrated here. An embodiment of the invention allows the openings to be filled with the air or liquid from the surrounding medium. Due to the limitation imposed by the solid's flat shape, it is not possible to increase the exposure of the fern-like fractal to the solid. However, the air or liquid outside of the solid are perfect for the fractal's exposure.

Under the phonon model of heat exchange, applicable to carbon nanotubes, graphene materials, and perhaps others, the fractal shape is advantageous to ensure the escape of the phonons into the surrounding fluid medium because the fractal guarantees close to maximal surface exposure to the medium and does not have many parts that are not exposed, as is a problem with many prior art heatsinks. Skilled persons in the art will realize that this could be achieved through many known structures. For example, graphene, which is one-atom-thick carbon and highly heat conductive, would be an advantageous material to use to build the fractal heatsink herein described.

When a turbulently flowing fluid passes around an obstacle, concave regions or cavities in the obstacle create pockets of separated flow which generates self-sustaining oscillations and acoustic resonance. The concave regions or cavities have substantially reduced narrow band acoustic resonance as compared to flat regions on the obstacle. This allows for more energy to be available for heat transfer. Skilled persons in the art will note that fractal structure **110,** as many other fractal structures, has a plurality of concave regions to allow for an implementation of this effect.

**Fig. 3** illustrates another embodiment of the invention. A solid to be cooled that has an arbitrary shape **290** is located inside (illustrated) or outside (not illustrated) a two-dimensional or three-dimensional roughly fractal shaped **210** heatsink. In one embodiment, the heatsink **210** has an aperture **270** designed to hold the solid. Alternatively, the solid to be cooled might be located outside of the heatsink (not illustrated). Note that, as in **Fig. 2,** the fractal heat exchange element has multiple motifs, starting with the large triangle at **210,** to progressively smaller triangles at **220** and **230.** However, note that the fractal does not keep extending infinitely and there are no triangles smaller than the one at **230.** In other words, the fractal heatsink **210** has multiple recursive fractal iterations **220** and **230,** but the fractal iterations stop at level **230** for simplicity of design and manufacturability. Also note that the fractal submotifs **220** and **230** are of different dimensional sizes from the original fractal motif **210** and protrude from the original fractal shape **210.** Here, the first motif is a large triangle, and the latter motifs are smaller triangles, which involve a rotation, linear displacement, and change of scale of the prior motif. In one embodiment, the fractal shape has some apertures in it (not illustrated) to allow the solid to be cooled to connect with other elements. Also, the solid to be cooled is connected to the fractal shape at point connector **240** and through bus wires at **250** and **260.** The solid should be connected to the fractal heatsink in at least one point, either through a point connection, a bus wire connection, or some other connection. If it is desired that the solid be fixed inside the heatsink, there may be at least three connection points, as illustrated. However, only one connection point is necessary for heat convection and radiation from the solid to the heatsink. Preferably, the point or bus wire connection is built using a strong heat conductor, such as carbon nanotubes or a diamond-like coating.

Note that, as in Fig. 1, the fractal structure 210 in Fig.2 has multiple concave regions or cavities. When a turbulently flowing fluid passes around this fractal heatsink, the concave regions or cavities substantially reduce the narrow band acoustic resonance as compared to a flat or Euclidian structure. This allows for more energy to be available to for heat transfer.

In yet another embodiment of the invention, the heatsink **210** in **Fig. 3** could be constructed without the connections at points **240, 250,** and **260.** In one embodiment, a liquid or gas would fill the aperture **270** with the intent that the liquid or gas surround the solid to be cooled, hold it in place, or suspend it. Preferably, the liquid or gas surrounding the solid would conduct heat from the solid to the heatsink, which would then cause the heat to exit.

Those skilled in the art will recognize many ways to fabricate the heatsinks described herein. For example, modern three-dimensional laser and liquid printers can create objects such as the heatsinks described herein with a resolution of features on the order of 16 $\mu$m. Also, it is possible to grow a crystal structure using a recursive growth algorithm or through crystal growth techniques. For example, US Patent Application No. 2006/0037177 by Blum, describes a method of controlling crystal growth to produce fractals or other structures through the use of spectral energy patterns by adjusting the temperature, pressure, and electromagnetic energy to which the crystal is exposed. This method might be used to fabricate the heatsinks described herein. For larger heatsinks, such as those intended to be used in car radiators, traditional manufacturing methods for large equipment can be adapted to create the fractal structures described herein.

In this disclosure, we have described several embodiments of this broad invention. Persons skilled in the art will definitely have other ideas as to how the teachings of this specification can be used. It is not our intent to limit this broad invention to the embodiments described in the specification. Rather, the invention is limited by the following claims.

**Claims**

1. A heatsink comprising:

   a heat exchange device having a flat base configured to interface with a heat source; and
   a plurality of heat exchange elements in a branched configuration having at least three levels of branching, **characterized in** the branched configuration extending in three dimensions, and having a fractal variation therebetween.

2. The heatsink according to claim 1, wherein a heat transfer fluid is induced to flow turbulently with respect to at least one of the plurality of heat exchange elements dependent on the fractal variation.

3. The heatsink according to claim 1, wherein the fractal variation in the plurality of heat exchange elements substantially distributes an acoustic emission power over a wide band, resulting from a forced air flow over the plurality of branched heat exchange elements.

4. The heatsink of claim 1, wherein the heat exchange device comprises an element whose heat conductivity exceeds 850 W/(m*K).

5. The heatsink of claim 1, where the heat exchange device comprises graphene.

6. The heatsink of claim 1, where the heat exchange device comprises diamond.

7. The heatsink of claim 1, where the heat exchange device comprises a composition having an extended regular lattice which effectively supports phonon transport.

8. The heatsink of claim 1, where the heat exchange device comprises carbon nanotubes.

9. The heatsink of claim 8, wherein the carbon nanotubes are aligned.

10. The heatsink of claim 1, further comprising at least one connector, configured to connect with a solid to be cooled in at least one point.

11. The heatsink of claim 10, wherein the at least one connector is selected from the group consisting of: a point connector, a bus, a wire, a planar connector, and a three-dimensional connector.

12. The heatsink of claim 1, further comprising an aperture in the center of the heatsink.

13. A method of cooling a solid comprising the steps of:

connecting the solid with a heatsink comprising a heat exchange device having a plurality of heat exchange elements in a branched configuration having a fractal branching pattern over at least three levels of branching extending in three dimensions;

transferring heat from the solid to the heatsink; and

dissipating the heat from the heatsink by flowing a heat transfer fluid over the plurality of heat exchange elements.

14. The method according to claim 13, wherein the flowing of the heat transfer fluid induces a broadband acoustic emission.

## Patentansprüche

1. Kühlkörper, welcher aufweist:

eine Wärmeaustauschvorrichtung, die eine flache Basis aufweist, die zur Wechselwirkung mit einer Wärmequelle konfiguriert ist; und

eine Mehrzahl von Wärmeaustauschelementen in einer verzweigten Konfiguration, die zumindest drei Verzweigungsgrade aufweist, **dadurch gekennzeichnet, dass** sich die verzweigte Konfiguration in drei Dimensionen erstreckt und dazwischen eine fraktale Variation aufweist.

2. Der Kühlkörper nach Anspruch 1, wobei ein Wärmeübertragungsfluid eingeführt wird, um in Bezug auf eines der Mehrzahl von Wärmeaustauschelementen in Abhängigkeit von der fraktalen Variation turbulent zu fließen.

3. Der Kühlkörper nach Anspruch 1, wobei die fraktale Variation in der Mehrzahl von Wärmeaustauschelementen eine akustische Emissionsleistung über ein breites Brand, resultierend aus einem erzwungenen Luftfluss über die Mehrzahl von verzweigten Wärmeaustauschelementen, im Wesentlichen verteilt.

4. Der Kühlkörper von Anspruch 1, wobei die Wärmeaustauschvorrichtung ein Element aufweist, dessen Wärmeleitfähigkeit 850W/(m•K) überschreitet.

5. Der Kühlkörper von Anspruch 1, wobei die Wärmeaustauschvorrichtung Graphen aufweist.

6. Der Kühlkörper von Anspruch 1, wobei die Wärmeaustauschvorrichtung Diamant aufweist.

7. Der Kühlkörper von Anspruch 1, wobei die Wärmeaustauschvorrichtung eine Zusammensetzung mit einem erweiterten regulären Gitter aufweist, das Phonon-Transport effektiv unterstützt.

8. Der Kühlkörper von Anspruch 1, wobei die Wärmeaustauschvorrichtung Karbonnanoröhrchen aufweist.

9. Der Kühlkörper von Anspruch 8, wobei die Karbonnanoröhrchen fluchten.

10. Der Kühlkörper von Anspruch 1, der ferner zumindest einen Verbinder aufweist, der zur Verbindung mit einem in zumindest einem Punkt zu kühlenden Festkörper konfiguriert ist.

11. Der Kühlkörper von Anspruch 10, wobei der zumindest eine Verbinder aus einer Gruppe ausgewählt ist, bestehend aus: einem Punktstecker, einem Bus, einem Draht, einem Flachstecker und einem dreidimensionalen Stecker.

12. Der Kühlkörper von Anspruch 1, der ferner in der Mitte des Kühlkörpers eine Öffnung aufweist.

13. Verfahren zum Kühlen eines Festkörpers, welches die Schritte aufweist:

Verbinden des Festkörpers mit einem Kühlkörper, der eine Wärmeaustauschvorrichtung aufweist, die eine Mehrzahl von Wärmeaustauschelementen in einer verzweigten Konfiguration aufweist, die ein fraktales Verzweigungsmuster über zumindest drei Verzweigungsgrade aufweist, die sich in drei Dimensionen erstrecken;

Übertragen von Wärme von dem Festkörper zu dem Kühlkörper; und

Abführen der Wärme von dem Kühlkörper durch den Fluss eines Wärmeübertragungsfluids über die Mehrzahl von Wärmeaustauschelementen.

**14.** Das Verfahren nach Anspruch 13, wobei der Fluss des Wärmeübertragungsfluids eine akustische Breitbandemission induziert.

**Revendications**

**1.** Puits thermique comprenant :

un dispositif d'échange thermique ayant une base plane configurée pour être en interface avec une source de chaleur ; et
une pluralité d'éléments d'échange thermique dans une configuration ramifiée ayant au moins trois niveaux de ramification, **caractérisé en ce que** la configuration ramifiée s'étend dans trois dimensions, et **en ce qu'**existe une variation fractale entre ceux-ci.

**2.** Puits thermique selon la revendication 1, dans lequel on induit l'écoulement d'un fluide de transfert thermique de manière turbulente par rapport à au moins l'un de la pluralité d'éléments d'échange thermique en fonction de la variation fractale.

**3.** Puits thermique selon la revendication 1, dans lequel la variation fractale dans la pluralité d'éléments d'échange thermique répartit sensiblement une puissance d'émission acoustique sur une large bande, résultant d'un écoulement d'air forcé sur la pluralité d'éléments d'échange thermique ramifiés.

**4.** Puits thermique de la revendication 1, dans lequel le dispositif d'échange thermique comprend un élément dont la conductivité thermique dépasse 850 W/(m*K).

**5.** Puits thermique de la revendication 1, où le dispositif d'échange thermique comprend du graphène.

**6.** Puits thermique de la revendication 1, où le dispositif d'échange thermique comprend du diamant.

**7.** Puits thermique de la revendication 1, où le dispositif d'échange thermique comprend une composition ayant un réseau régulier étendu qui contribue efficacement au transport de phonons.

**8.** Puits thermique de la revendication 1, où le dispositif d'échange thermique comprend des nanotubes de carbone.

**9.** Puits thermique de la revendication 8, dans lequel les nanotubes de carbone sont alignés.

**10.** Puits thermique de la revendication 1, comprenant en outre au moins un connecteur configuré pour être raccordé à un solide devant être refroidi en au moins un point.

**11.** Puits thermique de la revendication 10, dans lequel le connecteur, au moins au nombre de un, est choisi dans le groupe constitué de : un connecteur ponctuel, un bus, un fil, un connecteur planaire et un connecteur tridimensionnel.

**12.** Puits thermique de la revendication 1, comprenant en outre une ouverture au centre du puits thermique.

**13.** Procédé de refroidissement d'un solide comprenant les étapes de :

raccordement du solide à un puits thermique comprenant un dispositif d'échange thermique ayant une pluralité d'éléments d'échange thermique dans une configuration ramifiée ayant un motif fractal de ramifications sur au moins trois niveaux de ramification s'étendant dans trois dimensions ; transfert de chaleur du solide au puits thermique ; et
dissipation de la chaleur à partir du puits thermique par écoulement d'un fluide de transfert thermique sur la pluralité d'éléments d'échange thermique.

**14.** Procédé selon la revendication 13, dans lequel l'écoulement du fluide de transfert thermique induit une émission acoustique à large bande.

**Optimum plate spacing**

$$(1) \quad S_{opt} = k_s \cdot \left(\frac{L}{dT}\right)^{0.25} \cdot \cos(\gamma)^{-0.25}$$

$$\gamma_{opt} = a\tan\left(\frac{1}{3} \cdot \frac{H}{W}\right) \qquad \frac{H}{W} < \sqrt{3}$$

$$\gamma_{opt} = \frac{\pi}{4} - 0.508 \cdot \left(\frac{H}{W}\right)^{-1.237} \qquad \frac{H}{W} > \sqrt{3}$$

**Total heat dissiaption**

$$(2) \quad \dot{Q} = k_v \cdot k_\gamma \cdot A_c \cdot H^{0.5} \cdot dT^{1.5}$$

$$k_\gamma = \sqrt{1 + \frac{1}{9} \cdot \left(\frac{H}{W}\right)^2} \qquad \frac{H}{W} < \sqrt{3}$$

$$k_\gamma = 0.307 \cdot \left(\frac{H}{W}\right)^{-0.5} + 0.696 \cdot \left(\frac{H}{W}\right)^{0.5} \qquad \frac{H}{W} > \sqrt{3}$$

**Applied equation**

$$(3) \quad \dot{Q} = \eta_v \cdot k_v \cdot k_\gamma \cdot A_c \cdot H^{0.5} \cdot dT_{ref}^{1.5}$$

- - - - - - - - - - - - - - - - - - - -

$dT$ = Temperature difference [K]

$A_c = W \cdot D$

$\eta_v$ = Volumetric efficiency [–]

$\dot{Q}$ = Heat dissipation [W]

Fig. 1

13

Fig. 2

Fig. 3

**REFERENCES CITED IN THE DESCRIPTION**

**Patent documents cited in the description**

- US 200800115916 A1
- US 20080080137 A1
- US 20090321045 A, Hernon
- US 7256751 B, Cohen
- US 20060037177 A, Blum

**Non-patent literature cited in the description**

- **FOURIER, J. B. ; FREEMAN, A.** Theorie analytique de la chaleur, Paris. Dover Publications, Inc, 1955
- **KORDYBAN, T.** Hot air rises and heat sinks - Everything you know about cooling electronics is wrong. ASME Press, 1998
- Heat sink selection. **ANON, UNKNOWN.** Mechanical engineering department. San Jose State University, 27 January 2010
- **SERGENT, J. ; KRUM, A.** Thermal management handbook for electronic assemblies. McGraw-Hill, 1998
- **INCROPERA, FP ; DEWITT, DP.** Introduction to heat transfer. John Wiley & Sons, 1985
- **FORGHAN, F. ; GOLDTHWAITE, D. ; ULINSKI, M. ; METGHALCHI, M.** Experimental and Theoretical Investigation of Thermal Performance of Heat Sinks. *ISME,* May 2001
- **LASANCE, C.J.M ; EGGINK, H.J.** A Method to Rank Heat Sinks in Practice: The Heat Sink Performance Tester. *21st IEEE SEMI-THERM Symposium,* 2001
- **LIENARD, J.H.** A Heat Transfer Textbook. MIT, 2004
- **SAINT-GOBAIN.** *Thermal management solutions for electronic equipment,* 2004, www.fff.saint-gobain.com/Media/Documents/S0000000000000001036/ ThermaCool%20Brochure.pdf
- **JEGGELS, Y.U. ; DOBSON, R.T. ; JEGGELS, D.H.** Comparison of the cooling performance between heat pipe and aluminium conductors for electronic equipment enclosures. *Proceedings of the 14th International Heat Pipe Conference,* 2007
- **PRSTIC, S. ; IYENGAR, M. ; BAR-COHEN, A.** Bypass effect in high performance heat sinks. *Proceedings of the International Thermal Science Seminar Bled,* 11 June 2000
- **MILLS, A.F.** Heat transfer. Prentice Hall, 1999
- **POTTER, C.M. ; WIGGERT, D.C.** Mechanics of fluid. 2002
- **WHITE, F.M.** Fluid mechanics. McGraw-Hill International, 1999
- **AZAR, A et al.** Heat sink testing methods and common oversights. *Qpedia Thermal E-Magazine,* January 2009, www.qats.com/cpanel/UploadedPdf/January20092.pdf
- **FRIGUS PRIMORE.** *A Method for Comparing Heat Sinks Based on Reynolds Analogy,* 28 April 2010, www.frigprim.com/downloads/Reynolds_analogy_heatsinks.PDF
- **FRIGUS PRIMORE.** *Natural Convection and Inclined Parallel Plates,* 29 April 2010, www.frigprim.com/articels2/parallel_pl_Inc.html
- **FRIGUS PRIMORE.** *Natural Convection and Chimneys,* 29 April 2010, www.frigprim.com/articels2/parallel_plchim.html
- **PAUL BATTEN.** *Sub-Grid Turbulence Modeling for Unsteady Flow with Acoustic Resonance,* 29 April 2010, www.metacomptech.com/cfd++/00-0473.pdf
- **S. LIU.** Heat Transfer and Pressure Drop in Fractal Microchannel Heat Sink for Cooling of Electronic Chips. *Heat Mass Transfer,* 2007, vol. 44, 221
- **Y.J. LEE.** Enhanced Microchannel Heat Sinks Using Oblique Fins. *IPACK,* 2009, 89059
- **PENCE, D. V.** Reduced Pumping Power and Wall Temperature in Microchannel Heat Sinks with Fractal-like Branching Channel Networks. *Microscale Thermophys. Eng.,* 2002, vol. 5, 293-311
- **NJ RYAN ; DA STONE.** Application of the FD-TD method to modelling the electromagnetic radiation from heatsinks. *IEEE International Conference on Electromagnetic Compatibility,* 01 September 1997, 119-124
- **LANCE COVERT ; JENSHAN LIN ; DAN JANNING ; THOMAS DALRYMPLE.** 5.8 GHz orientation-specific extruded-fin heatsink antennas for 3D RF system integration. *Microwave and Optical Technology Letters,* 23 April 2008, vol. 50 (7), 1826-1831

- **MANDELBROT, B.B.** *a rough or fragmented geometric shape that can be split into parts, each of which is (at least approximately) a reduced-size copy of the whole,* 1982
- The Fractal Geometry of Nature. W.H. Freeman and Company
- **BORIS YAKOBSON.** Acoustic waves may cool microelectronics. *Nano Letters, ACS,* 2010